# EUROPEAN PATENT SPECIFICATION

(11) **EP 2 973 657 B1**
(45) Date of publication and mention of the grant of the patent: **20.06.2018**
(21) Application number: 14779860.7
(22) Date of filing: 28.02.2014
(51) Int. Cl.: H01L 21/00

(54) **SURFACE ROUGHENING TO REDUCE ADHESION IN AN INTEGRATED MEMS DEVICE**
OBERFLÄCHENAUFRAUHUNG ZUR REDUZIERUNG DER HAFTUNG IN EINER INTEGRIERTEN MEMS-VORRICHTUNG
RUGOSIFICATION DE SURFACE POUR RÉDUIRE L'ADHÉRENCE DANS UN DISPOSITIF MEMS INTÉGRÉ

(30) Priority: 13.03.2013 US 201361780776 P; 23.10.2013 US 201314061152
(43) Date of publication of application: 20.01.2016
(73) Proprietor: InvenSense, Inc., San Jose, CA 95110 (US)
(72) Inventor: WILLIAMS, Kirt Reed, San Jose, CA 95110 (US); HUANG, Kegang, San Jose, CA 95110 (US); XU, Wencheng, San Jose, CA 95110 (US); SHIN, Jongwoo, San Jose, CA 95110 (US); LIM, Martin, San Jose, CA 95110 (US)
(74) Representative: Smith, Jeremy Robert
(86) International application number: PCT/US2014/019661
(87) International publication number: WO 2014/163985

(56) References cited:
- US-A1- 2002 146 200
- US-A1- 2003 190 814
- US-A1- 2004 038 045
- US-A1- 2006 278 942
- US-A1- 2007 082 420
- US-A1- 2008 081 391
- US-A1- 2008 081 391
- US-A1- 2009 159 410
- US-A1- 2011 091 687
- US-A1- 2011 188 109
- US-A1- 2012 299 129
- US-B1- 8 350 346

## Description

### FIELD OF THE INVENTION

The present invention relates generally to integrated MEMS devices and more particularly to a system and method for reducing adhesion in such devices.

### BACKGROUND

Integrated MEMS devices (with dimensions from 0.01 to 1000 um) have moving MEMS parts with smooth surfaces. When the surfaces come into contact, they can adhere or stick together (often referred to as "stiction"). The adhesion force, which must be overcome in order to separate the parts from each other, originates from the surface adhesion energy that is proportional to the area of atomic contact. Accordingly what is needed is a system and method to reduce the adhesion force in such devices. The present invention addresses such a need.

US 2008/0081391 discloses a MEMS device with roughened surface and method of producing the same. A method of producing a MEMS device provides a MEMS apparatus having released structure. The MEMS apparatus is formed at least in part from an SOI wafer having a first layer, a second layer spaced from the first layer, and an insulator layer between the first layer and second layer.

US 2006/0278942 discloses an antistiction MEMS substrate and method of manufacture. A composite wafer for fabricating MEMS devices is provided with a plurality of antistiction bumps, buried under a device layer of the composite wafer. The antistiction bumps are prepared lithographically, by patterning an antistiction material prior to the assembly of the composite wafer.

### SUMMARY

Methods and systems for reducing adhesion in an integrated MEMS device are disclosed. In a first aspect, an integrated MEMS device comprises a MEMS substrate having a first contacting surface; a base substrate coupled to the MEMS substrate having a second contacting surface of the MEMS device. At least one of the first contacting surface and the second contacting surface is roughened in a predetermined manner. The MEMS substrate faces one or more fixed bump stops on the base substrate and the surface of the one or more fixed bump stops is roughened.

In a second aspect, a method to reduce surface adhesion forces in an integrated MEMS device is disclosed. The integrated MEMS device including a MEMS substrate having a first contacting surface and a base substrate coupled to the MEMS substrate having a second contacting surface and one or more fixed bump stops on the base substrate, the method comprises etching at least one of the first contacting surface and the second contacting surface to roughen at least one of the first contacting surface and the second contacting surface and etching the surface of the one or more fixed bump stops to roughen the surface of the one or more fixed bump stops.

In an example, a method to reduce surface adhesion forces in an integrated MEMS device is disclosed. The integrated MEMS device including a MEMS substrate having a first contacting surface and a base substrate coupled to the MEMS substrate having a second contacting surface. The method comprises depositing a rough film onto one of the first contacting surface and the second contacting surface; and plasma etching the rough film through and into the one of the first contacting surface and the second contacting surface. The roughness on the rough film will be transferred into the one of the first contacting surface and the second contacting surface.

### BRIEF DESCRIPTION OF THE DRAWINGS

Figure 1A shows a cross section drawing of a bonded base substrate-MEMS device with moving MEMS silicon parts which can move and touch the bump stops on base substrate.
Figure 1B shows a cross section drawing of a bonded base substrate-MEMS device with moving MEMS silicon parts which can move and touch the bump stops on the base substrate and at least one of the contacting surfaces are roughened.
Figures 2A - 2E show a series of cross section drawings of base substrate processing steps to complete the base substrate with bump stops having a rough surface.
Figures 3A - 3D show a series of cross section drawings of a first embodiment of MEMS substrate processing steps to complete a MEMS wafer with silicon structures having a rough surface.
Figures 4A-4D show a series of cross-section drawings of a second embodiment of a MEMS substrate processing steps to provide a rough surface on the MEMS substrate.

### DETAILED DESCRIPTION

The present invention relates generally to integrated MEMS devices and more particularly to a system and method for reducing adhesion in such devices.

In the described embodiments Micro-Electro-Mechanical Systems (MEMS) refers to a class of structures or devices fabricated using semiconductor-like processes and exhibiting mechanical characteristics such as the ability to move or deform. MEMS often, but not always, interact with electrical signals. MEMS devices include but not limited to gyroscopes, accelerometers, magnetometers, microphones, and pressure sensors.

In the described embodiments, MEMS device may refer to a semiconductor device implemented as a micro-electro-mechanical system. MEMS structure may refer to any feature that may be part of a larger MEMS device. In the described embodiments, device layer may refer to the silicon substrate in which the MEMS structure is formed. An Engineered silicon-on-insulator (ESOI) wafer may refer to a SOI wafer with cavities underneath the device wafer. Base substrate may include CMOS substrate or any other semiconductor substrate. In certain embodiments, base substrate may include electrical circuits. Handle wafer typically refers to a thicker semiconductor substrate used as a carrier for the MEMS substrate. In certain embodiments, the handle wafer is the base of a silicon-on-insulator wafer. Handle substrate, handle layer, and handle wafer can be interchanged. The MEMS substrate includes the device layer and the handle layer.

In the described embodiments, a cavity may refer to an opening in a substrate wafer and enclosure may refer to a fully enclosed space. Standoff may be a vertical structure providing electrical contact.

A MEMS device with one or both contacting surfaces being roughened, and fabrication methods to achieve rough surfaces for one or both surfaces of the two contacting parts are disclosed. The roughness of the contacting surfaces reduces the surface adhesion energy, therefore the sticking force, preventing the contacting surfaces stick to each other.

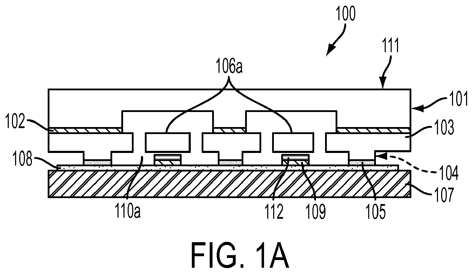

Figure 1A shows a cross section drawing of a bonded base substrate-MEMS device 100 with movable structure 106a which can come in contact with the bump stop 110a on base substrate 107. The MEMS substrate 111 includes a handle substrate 101 with cavities etched into it and a device layer 103, bonded together with a thin dielectric film 102 (such as silicon oxide) in between. In some embodiments, the device layer 103 is made of single crystal silicon. Standoff 104 is formed with a germanium (Ge) film 105 on top of the standoff 104. The MEMS substrate 111 is completed after the device layer 103 is patterned and etched to form movable structure 106a.

The MEMS device 100 includes a base substrate 107. A layer of conductive material 108 is deposited on the base substrate to provide electrical connection from the device layer 103 to the base substrate 107. In an embodiment, the base substrate-MEMS integration is achieved by eutectic bonding of Ge 105 on the MEMS substrate 111 with the aluminum 108 of the base substrate 107. The bump stop 110a on base substrate 107 is a stationary structure that limits the motion of the moveable structure 106a. In an embodiment, the MEMS substrate 111 and the base substrate 107 are bonded to form the base substrate-MEMS device 100. In an embodiment, bump stop 110a has a layer of silicon nitride (SiN) 112 over a layer of silicon oxide 109. Both Si and SiN surfaces are smooth with a roughness of about 0.5 to 2.5 nm (rms) without a surface treatment or etch.

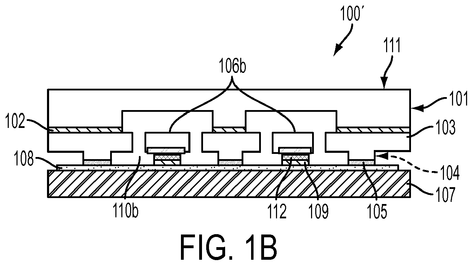

Figure 1B shows a cross section drawing of the bonded base-substrate MEMS device 100 with movable structure 106b which can move and touch the bump stops 110b on the base substrate. In this embodiment, one of or both movable structure 106b surface and bump stop 110b surfaces can be roughened.

By roughening one or both of the surfaces, the area of atomic contact is reduced and hence the adhesion energy or stiction force is reduced. Surface roughening can be done by etching the surfaces of the movable structure 106b or the surfaces of stationary bump stops 110b in a gas, plasma, or liquid with locally non-uniform etch rate. In this embodiment, the surface of the movable structure 106b or the surface of the bump stop 110b, or both surfaces can be roughened by various processing techniques to reduce the area of atomic surface contact, and thus the adhesion force when the movable structure 106b comes in contact with bump stop 110b. In an embodiment, the movable structure 106b can be made of silicon and the bump stop 110b can be made of SiN. Other embodiments can have bump stop 110bsurfaces made of any other material such as silicon oxide, aluminum or, titanium nitride (TiN).

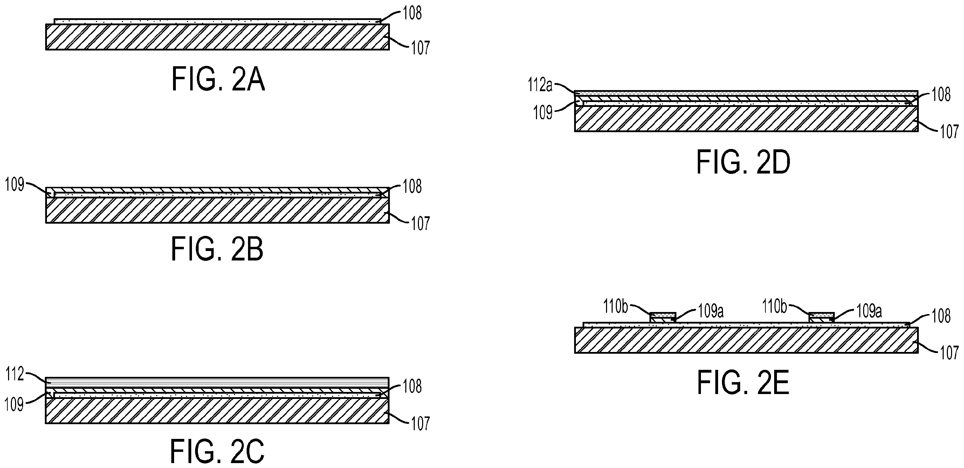

In an embodiment, Figures 2A - 2E show a series of cross section drawings of base substrate processing steps to complete a base substrate with bump stops having a rough surface. Figure 2A shows the cross-section of a base substrate 107 with a conductive layer 108 such as aluminum (Al) deposited, patterned and etched. As shown in Figure 2B, an Inter-Metal Dielectric (IMD) silicon oxide layer 109 is deposited on patterned conductive layer 108 and chemical mechanical polished (CMPed) to planarize the IMD silicon oxide layer 109. Figure 2C shows a blanket passivation SiN film 112 deposited on the planarized IMD silicon oxide layer 109. The SiN film 112 has a smooth surface with a root-mean-square (RMS) roughness in the order of 1 - 3 nm (nanometers). In an embodiment, to initiate the surface roughening process, a thin film of silicon carbide (SiC) or amorphous Si (not shown) can be deposited onto the SiN film 112.

Figure 2D shows the cross section of a base substrate 107 with a roughened SiN surface 112a achieved by local non-uniform etching with wet chemical, gas, or plasma processing. In an embodiment with bump stops with a top layer of SiN film, roughness can be obtained from oxygen-free plasma etching of SiN film 112 using a mixture of CF₄/H₂ or SF₆/CH₄/N₂ gas combinations. In the embodiment with bump stops with a top layer of SiC or amorphous Si film, the SiC or amorphous Si film can be etched with a plasma etch followed by further SiN etch for rougher surface.

Figure 2E shows the cross section of the completed base substrate 107 after passivation SiN, and patterning and etching IMD silicon oxide layer 109a to form bump stop 110b, with a top layer of SiN 112a with a rough surface on bump stop 110b.

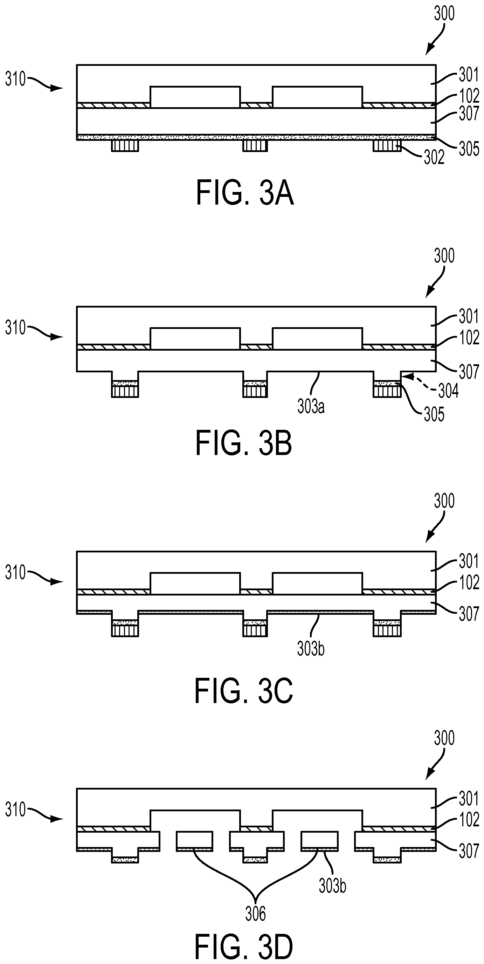

Figures 3A - 3D show a series of cross section drawings of MEMS substrate 300 processing steps to complete the MEMS device with moveable structures having a rough surface in an embodiment. Figure 3A shows a cross-section of an engineered SOI (ESOI)) wafer 310 comprised of a device layer 307 and a handle substrate 301 with cavities. The device layer 307 and a handle substrate 301 are bonded with a thin dielectric film 102 in between. In an embodiment, the device layer 307 can be thinned before subsequent bonding to a base substrate. A Ge film 305 is deposited onto the device layer 307 followed by coating and patterning photoresist 302 to define a standoff. In an embodiment, as shown in Figure 3B, a wet etching step can be performed on the Ge film 305 and a dry etching can be performed on a portion of the device layer 307 to expose a surface 303a of the device layer 307 to form standoff 304 with a Ge film 305 on top.

In an embodiment shown in Fig 3C, the standoff 304 is etched after depositing and patterning the Ge film 305. As shown in Figure 3C exposed surface 303a is etched to form a rough surface 303b, followed by the removal of the patterned photoresist 302 and cleaning of the wafer. In different embodiment, the standoff 304 is patterned and etched before depositing and patterning Ge film 305.

In an embodiment, the surface 303a of the device layer 307 can be roughened by a plasma-less process such as isotropic silicon wet etch or isotropic silicon dry etch processes. Xenon diflouride (XeF2) dry chemical etch is an example of isotropic etch processes. In an embodiment, the wet etchant contains choline (C₅H₁₄NO), potassium hydroxide (KOH), sodium hydroxide (NaOH), lithium hydroxide (LiOH), ethylene diamine pyrocatechol (EDP), tetramethylammonium hydroxide (TMAH), or TMEH. Examples of plasma-less etching gases are xenon diflouride (XeF₂), bromine difluoride (BrF₂), iodine pentafluoride (IF₅), bromine pentafluoride (BrF₅), chlorine triflouride (ClF₃), or fluorine (F₂).

In an embodiment, the surface 303a of the device layer 307 can be roughened by a plasma etch. Sulfur hexafluoride (SF₆) plasma dry etch processes is an example of plasma etching process. In an embodiment, the plasma etching gas contains at least one of SF₆, CF₄, Cl₂, HBr, He, Ne, Ar, Kr, or Xe. In an embodiment, the roughness of the etched surface 303a could be in the order of 5 - 20 nm.

Figure 3D, shows a completed MEMS substrate 300. In an embodiment, the rough device layer 307 is patterned, and etched to release the MEMS structure 306, Later, MEMS structure 306 is cleaned.

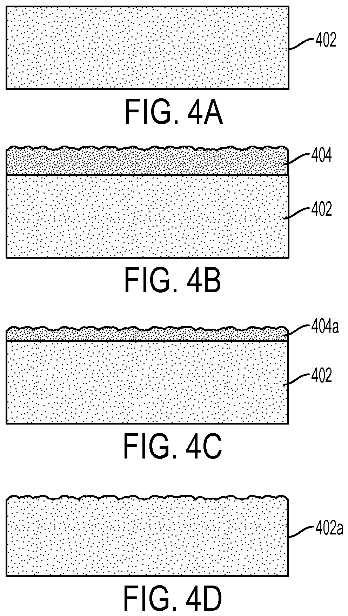

Figures 4A-4D show a series of cross-section drawings of a second embodiment of the processing steps of providing a rough surface on a silicon substrate.

In an embodiment, Fig 4A shows a silicon substrate 402 with a smooth surface. Figure 4B shows a thin layer of a film 404 with a rough surface deposited onto the smooth surface of the silicon substrate 402 to initiate the roughness. In an embodiment, the rough film 404 can be made of poly silicon or silicon carbide. In some embodiments, the rough film 404 provides a rough surface on the silicon substrate 402 and no further etching is required, steps shown in Fig 4C and Fig 4D are optional. Other embodiments include further etching of the rough surface. Figure 4C shows an intermediate step of etching the rough film 404, resulting in a thinner film 404a. In an embodiment, the etching step can be performed by wet etching or dry etching. Figure 4D, shows the final step, where further etching transfers the roughness of the rough film 404a to the silicon substrate 402a.

## Claims

1. An integrated MEMS device (100) comprising:
a MEMS substrate (111) having a first contacting surface; and
a base substrate (107) coupled to the MEMS substrate having a second contacting surface;
wherein at least one of the first contacting surface and the second contacting surface is roughened;
wherein the MEMS substrate includes a handle layer (101) coupled to a device layer (103);
the device layer comprises a movable structure (106) suspended above and parallel to the base substrate;
the MEMS substrate faces one or more fixed bump stops (110) on the base substrate; and
the surface of the one or more fixed bump stops is roughened.

2. The device (100) of claim 1, wherein the roughness of a surface of the movable structure (106) facing the base substrate (107) is greater than 4 nm-rms.

3. The device (100) of claim 1, wherein roughness of the one or more fixed bump stops (110) is greater than 4 nm-rms.

4. The device (100) of claim 1, wherein one or more fixed bump stops (110) is a dielectric material.

5. The device (100) of claim 1, wherein the one or more fixed bump stops (110) is a conducting material.

6. The device (100) of claim 1, wherein the one or more fixed bump stops (110) is a semiconducting material.

7. The device (100) of claim 1, wherein the movable structure (106) is a portion of any of an actuator, accelerometer, a microphone, a gyroscope, a pressure sensor, or a magnetometer.

8. The device (100) of claim 1, wherein the handle layer (101) includes a cavity.

9. A method to reduce surface adhesion forces in an integrated MEMS device (100); the integrated MEMS device including a MEMS substrate (110) having a first contacting surface and a handle layer (101) coupled to a device layer (103), the device layer comprising a movable structure (106) suspended above and parallel to the base substrate, the integrated MEMS device further including a base substrate coupled to the MEMS substrate having a second contacting surface and one or more fixed bump stops (110) on the base substrate, the method comprising:
etching at least one of the first contacting surface and the second contacting surface to roughen the at least one of the first contacting surface and the second contacting surface; and
etching the surface of the one or more fixed bump stops to roughen the surface of the one or more fixed bump stops.

10. The method of claim 9 wherein the etching comprises using a plasma-less etching gas to roughen the surface.

11. The method of claim 10, where the plasma-less etching gas contains at least one of xenon and fluorine.

12. The method of claim 9, wherein the etching comprises using a plasma etching gas to roughen the one contacting surface.

13. The method of claim 12, where the plasma etching gas contains at least one of SF₆, CF4, F2, O2, N2, CH4, and Xe.

14. The method of claim 9 wherein the etching comprises using a wet etchant to roughen the one contacting surface.

15. The method of claim 14, where the wet etchant contains choline, KOH, NaOH, LiOH, TMAH, or TMEH.

## Patentansprüche

1. Integrierte MEMS-Vorrichtung (100), umfassend:
ein MEMS-Substrat (111) mit einer ersten Kontaktoberfläche; und
ein Basissubstrat (107), das an das MEMS-Substrat mit einer zweiten Kontaktoberfläche gekoppelt ist;
wobei mindestens eine der ersten Kontaktoberfläche und der zweiten Kontaktoberfläche aufgeraut ist;
wobei das MEMS-Substrat eine Griffschicht (101) einschließt, die an eine Vorrichtungsschicht (103) gekoppelt ist;
die Vorrichtungsschicht eine bewegliche Struktur (106) umfasst, die über und parallel zu dem Basissubstrat aufgehängt ist;
das MEMS-Substrat zu einem oder mehreren festen Anschlagpuffern (110) auf dem Basissubstrat weist; und
die Oberfläche des einen oder der mehreren festen Anschlagpuffern aufgeraut ist.

2. Vorrichtung (100) nach Anspruch 1, wobei die Rauheit einer Oberfläche der beweglichen Struktur (106), die zu dem Basissubstrat (107) weist, größer als 4 nm-rms ist.

3. Vorrichtung (100) nach Anspruch 1, wobei die Rauheit des einen oder der mehreren festen Anschlagpuffer (110) größer als 4 nm-rms ist.

4. Vorrichtung (100) nach Anspruch 1, wobei einer oder mehrere feste Anschlagpuffer (110) ein dielektrisches Material ist bzw. sind.

5. Vorrichtung (100) nach Anspruch 1, wobei der eine oder die mehreren festen Anschlagpuffer (110) ein leitfähiges Material ist bzw. sind.

6. Vorrichtung (100) nach Anspruch 1, wobei der eine oder die mehreren festen Anschlagpuffer (110) ein Halbleitermaterial ist bzw. sind.

7. Vorrichtung (100) nach Anspruch 1, wobei die bewegliche Struktur (106) ein Anteil von einem beliebigen von einem Aktor, einem Beschleunigungsmesser, einem Mikrophon, einem Gyroskop, einem Drucksensor oder einem Magnetometer ist.

8. Vorrichtung (100) nach Anspruch 1, wobei die Griffschicht (101) einen Hohlraum einschließt.

9. Verfahren zum Reduzieren von Oberflächenhaftkräften in einer integrierten MEMS-Vorrichtung (100); wobei die integrierte MEMS-Vorrichtung ein MEMS-Substrat (110) mit einer ersten Kontaktoberfläche und einer Griffschicht (101) einschließt, die an eine Vorrichtungsschicht (103) gekoppelt ist, wobei die Vorrichtungsschicht eine bewegliche Struktur (106) umfasst, die oberhalb und parallel zu dem Basissubstrat aufgehängt ist, wobei die integrierte MEMS-Vorrichtung ferner ein Basissubstrat, das an das MEMS-Substrat gekoppelt ist, mit einer zweiten Kontaktoberfläche und einem oder mehreren festen Anschlagpuffern (110) auf dem Basissubstrat einschließt, wobei das Verfahren umfasst:
Ätzen von mindestens einer der ersten Kontaktoberfläche und der zweiten Kontaktoberfläche, um die mindestens eine von der ersten Kontaktoberfläche und der zweiten Kontaktoberfläche aufzurauen; und
Ätzen der Oberfläche des einen oder der mehreren festen Anschlagpuffer, um die Oberfläche des einen oder der mehreren festen Anschlagpuffer aufzurauen.

10. Verfahren nach Anspruch 9, wobei das Ätzen Verwenden eines plasmalosen Ätzgases zum Aufrauen der Oberfläche umfasst.

11. Verfahren nach Anspruch 10, wobei das plasmalose Ätzgas mindestens eines von Xenon und Fluor enthält.

12. Verfahren nach Anspruch 9, wobei das Ätzen Verwenden eines Plasmaätzgases zum Aufrauen der einen Kontaktoberfläche umfasst.

13. Verfahren nach Anspruch 12, wobei das Plasmaätzgas mindestens eines von SF₆, CF₄, F₂, O₂, N₂, CH₄ und Xe enthält.

14. Verfahren nach Anspruch 9, wobei das Ätzen Verwenden eines Nassätzmittels zum Aufrauen der einen Kontaktoberfläche umfasst.

15. Verfahren nach Anspruch 14, wobei das Nassätzmittel Cholin, KOH, NaOH, LiOH, TMAH oder TMEH enthält.

## Revendications

1. Dispositif MEMS intégré (100) comprenant :
un substrat MEMS (111) ayant une première surface de contact ; et
un substrat de base (107) couplé au substrat MEMS ayant une seconde surface de contact ;
où au moins l'une de la première surface de contact et de la seconde surface de contact est rendue rugueuse ;
où le substrat MEMS comprend une couche de poignée (101) couplée à une couche de dispositif (103) ;
la couche de dispositif comprend une structure mobile (106) suspendue au-dessus et parallèle au substrat de base ;
le substrat MEMS fait face à une ou plusieurs butées fixes (110) sur le substrat de base ; et
la surface des une ou plusieurs butées fixes est rendue rugueuse.

2. Dispositif (100) selon la revendication 1, dans lequel la rugosité d'une surface de la structure mobile (106) faisant face au substrat de base (107) est supérieure à 4 nm en valeur efficace.

3. Dispositif (100) selon la revendication 1, dans lequel la rugosité des une ou plusieurs butées fixes (110) est supérieure à 4 nm en valeur efficace.

4. Dispositif (100) selon la revendication 1, dans lequel les une ou plusieurs butées fixes (110) sont un matériau diélectrique.

5. Dispositif (100) selon la revendication 1, dans lequel les une ou plusieurs butées fixes (110) sont un matériau conducteur.

6. Dispositif (100) selon la revendication 1, dans lequel les une ou plusieurs butées fixes (110) sont un matériau semi-conducteur.

7. Dispositif (100) selon la revendication 1, dans lequel la structure mobile (106) est une partie d'un dispositif quelconque parmi un actionneur, un accéléromètre, un microphone, un gyroscope, un capteur de pression ou un magnétomètre.

8. Dispositif (100) selon la revendication 1, dans lequel la couche de poignée (101) comprend une cavité.

9. Procédé pour réduire les forces d'adhérence de surface dans un dispositif MEMS intégré (100) ; le dispositif MEMS intégré comprenant un substrat MEMS (110) ayant une première surface de contact et une couche de poignée (101) couplée à une couche de dispositif (103), la couche de dispositif comprenant une structure mobile (106) suspendue au-dessus et parallèle au substrat de base, le dispositif MEMS intégré comprenant en outre un substrat de base couplé au substrat MEMS ayant une seconde surface de contact et une ou plusieurs butées fixes (110) sur le substrat de base, le procédé comprenant les étapes suivantes :
graver au moins une surface parmi la première surface de contact et la seconde surface de contact pour rendre rugueuse au moins une surface parmi la première surface de contact et la seconde surface de contact ; et
graver la surface des au moins une ou plusieurs butées fixes pour rendre rugueuse la surface des une ou plusieurs butées fixes.

10. Procédé selon la revendication 9, dans lequel la gravure comprend d'utiliser un gaz de gravure sans plasma pour rendre la surface rugueuse.

11. Procédé selon la revendication 10, dans lequel le gaz de gravure sans plasma contient au moins un élément parmi le xénon et le fluor.

12. Procédé selon la revendication 9, dans lequel la gravure comprend d'utiliser un gaz de gravure au plasma pour rendre rugueuse la surface de contact.

13. Procédé selon la revendication 12, dans lequel le gaz de gravure au plasma contient au moins l'un des éléments suivants : SF6, CF4, F2, 02, N2, CH4 et Xe.

14. Procédé selon la revendication 9, dans lequel la gravure comprend d'utiliser un agent de gravure humide pour rendre rugueuse la surface de contact.

15. Procédé selon la revendication 14, dans lequel l'agent de gravure humide contient de la choline, du KOH, du NaOH, du LiOH, du TMAH, du TMAH ou du TMEH.
